(19) Europäisches Patentamt
European Patent Office
Office européen des brevets

(11) Veröffentlichungsnummer: **0 006 444**
**B1**

# (12) EUROPÄISCHE PATENTSCHRIFT

(45) Veröffentlichungstag der Patentschrift: **22.12.82**

(51) Int. Cl.³: **H 05 K 1/14**, H 01 L 23/50, H 05 K 3/00, H 05 K 3/36

(21) Anmeldenummer: **79101564.7**

(22) Anmeldetag: **22.05.79**

## (54) Vielschichtiges, dielektrisches Substrat.

(30) Priorität: **23.06.78 US 918213**
**23.06.78 US 918214**

(43) Veröffentlichungstag der Anmeldung: **09.01.80 Patentblatt 80/1**

(45) Bekanntmachung des Hinweises auf die Patenterteilung: **22.12.82 Patentblatt 82/51**

(84) Benannte Vertragsstaaten: **DE FR GB**

(56) Entgegenhaltungen:
**DE-A-2 011 628**
**DE-A-2 736 055**
**DE-A-2 742 534**
**GB-A-1 366 601**
**US-A-3 456 158**
**US-A-3 518 756**
**US-A-4 037 047**

(73) Patentinhaber: **International Business Machines Corporation, Armonk, N.Y. 10504 (US)**

(72) Erfinder: **Dougherty, William Edwin, Apt. 4A Wildwood Manor, Wappingers Falls, N.Y. (US)**
Erfinder: **Greer, Stuart Eugene, 56 Timberline Drive, Poughkeepsie, N.Y. (US)**

(74) Vertreter: **Kirchhof, Norbert, Ing. grad., Schönaicher Strasse 220, D-7030 Böblingen (DE)**

**EP 0 006 444 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

# Vielschichtiges, dielektrisches Substrat

Die Erfindung bezieht sich auf ein vielschichtiges, dielektrisches Substrat.

Da integrierte Schaltungen immer grossflächiger werden und an dieselben immer höhere Betriebsanforderungen gestellt werden, wird es notwendig, elektrische Zwischenpackungen vorzusehen, die den Betriebsanforderungen dieser Schaltkreise gerecht werden. Um dichtere Schaltkreise zu erhalten, wurde der Versuch unternommen, vielschichtige Glas-, Keramik- oder keramische mikroelektronische Strukturen zu verwenden, die zusammengesetzte, dielektrische Körper aufweisen, welche elektrisch verbundene leitende Muster besitzen, in einer Mehrzahl von horizontalen Ebenen.

Ein übliches Verfahren zur Herstellung solcher vielschichtiger, dielektrischer Substrate schliesst die Bildung keramischer oder glaskeramischer Partikel in einer Masse aus einem Bindemittel und einem Lösungsmittel ein, die Bildung der Masse aus einem Schlamm mit Umwandlung durch Eindampfen des Lösungsmittels in ein flexibles Schichtblatt von erforderlicher Grösse, das als nicht verarbeitetes Ausgangsblatt bezeichnet wird, die Bildung von Anschlusslöchern und Durchgangslöchern an vorher bestimmten Stellen in separaten Schichtblättern, das Niederschlagen einer Elektrodenpaste auf gewünschten Flächen der separaten Schichtblätter gleichzeitig in den Durchgangslöchern, das Übereinanderlagern der Schichtblätter mit erforderlicher Justierung und das Brennen der übereinandergeschichteten Blätter zum Ausbrennen des Binders und zum Sintern der dielektrischen Partikel und zur Verwandlung der Paste in elektrische Leiter, wodurch sich ein monolithischer Aufbau ergibt. An einem geeigneten Punkt des Herstellungsverfahrens werden Kontaktstifte in die Anschlusslöcher zur Herstellung elektrischer Wege von diesen Leitern zu externen Schaltungen eingebettet. Ein derartiges Herstellungsverfahren ist in den US-Patentschriften 3 518 756 und 3 988 405 und in dem Aufsatz «Ein Herstellungsverfahren für vielschichtige keramische Moduls» von H.D. Kaiser, «Solid State Technologie» vom Mai 1977, Seiten 35 bis 40 und im Aufsatz «Die dritte Dimension in Dickfilmvielschichttechnologien» von W.L. Clough «Micro Electronics» Vol. 13, Nr. 9 (1970) Seiten 23 bis 30 beschrieben.

Mehrschichtige keramische Schaltkreisplatten sind aus DE-A-20 11 628, DE-A-27 36 055 und US-A-4 037 047 bekannt.

Obwohl die vorgenannte Technik Anerkennung fand, ist sie bei kontinuierlicher Zunahme der Dichte der integrierten Schaltungen grossen Begrenzungen unterworfen. Diese Situation erfordert eine erhöhte Komplexität der inneren metallurgischen Muster, die in dem vielschichtigen, dielektrischen Substrat oder Modul eingebettet sind, hinsichtlich der Anzahl der erforderlichen Leiterschichten zusammen mit der Anzahl von zwischenverbindenden Durchgangslöchern und der erhöhten Anzahl von Anschlussstiften, die zur elektrischen Verbindung mit einer entsprechend erhöhten Anzahl von Kontaktpunkten auf aktiven Flächen der integrierten Schaltungsvorrichtung erforderlich sind. Solche Strukturen sind auch charakterisiert durch Durchgangswulste, welche die Ebenheit der Strukturen beeinträchtigen.

Ein Substrat der vorgenannten Art ist auch in GB-A-1 366 601 beschrieben, bei dem die Leiterbahnen der einzelnen Schichten sowohl untereinander als auch mit Anschlussstiften elektrisch verbunden sind. Diese elektrischen Verbindungen werden geschaffen durch Ausfüllen von Löchern mit einem Leitermaterial. Die elektrischen Verbindungen werden entsprechend dem Verwendungszweck einmal festgelegt, so dass das fertige Substrat nur für diesen speziellen Anwendungsfall verwendbar ist.

Die Erfindung, wie sie in den Ansprüchen gekennzeichnet ist, löst die Aufgabe, ein vielschichtiges, dielektrisches Substrat zur Aufnahme und elektrischen Verbindung von integrierten Schaltungsvorrichtungen so auszubilden, dass das Substrat mit einem einheitlichen Grundaufbau auf einfache Art an verschiedene Verwendungszwekke anpassbar ist.

Das erfindungsgemässe Substrat benötigt keine Löcher, die zwecks Verbindens von Leiterbahnen verschiedener Schichten mit einem leitenden Material auszufüllen sind. Die Herstellung wird dadurch wesentlich vereinfacht. Durch die an dem gegenüber dem Eingangsanschlussfeld eine gröbere Rasterteilung aufweisenden Ausgangsanschlussfeld anbringbaren Verteilungsleitungen ist das erfindungsgemässe Substrat an die verschiedensten Verwendungszwecke anpassbar. Durchgangslöcher sind nur für die Anbringung von Kontaktstiften notwendig, jedoch nicht für ihren elektrischen Anschluss.

Einzelheiten der Erfindung sind nachstehend anhand von in den Figuren veranschaulichten Ausführungsbeispielen beschrieben.

Es zeigen:

Fig. 1 übereinandergelagerte, dielektrische, nicht verarbeitete, rohe Schichtblätter in schaubildlicher Darstellung,

Fig. 2 eine Draufsicht auf ein Vielleitermuster auf einem nicht verarbeiteten Mutterrohblatt,

Fign. 3A und 3B Einzelheiten einer Einheit aus übereinandergelagerten Rohblättern in schaubildlicher Darstellung,

Fign. 4A und 4C Detailansichten von gebrannten, dielektrischen Substraten, die an verschiedene Anwendungen angepasst sind,

Fig. 5 einen Aufbau von Rohschichtblättern,

Fig. 6 eine Ansicht einer Verwendung des Aufbaues nach Fig. 4 im Halbleitergebiet,

Fig. 7 eine konstruktive Möglichkeit für ein eingebettetes Leitermuster,

Fign. 8A und 8C weitere konstruktive Ausgestaltungen der Erfindung in schaubildlicher Darstellung.

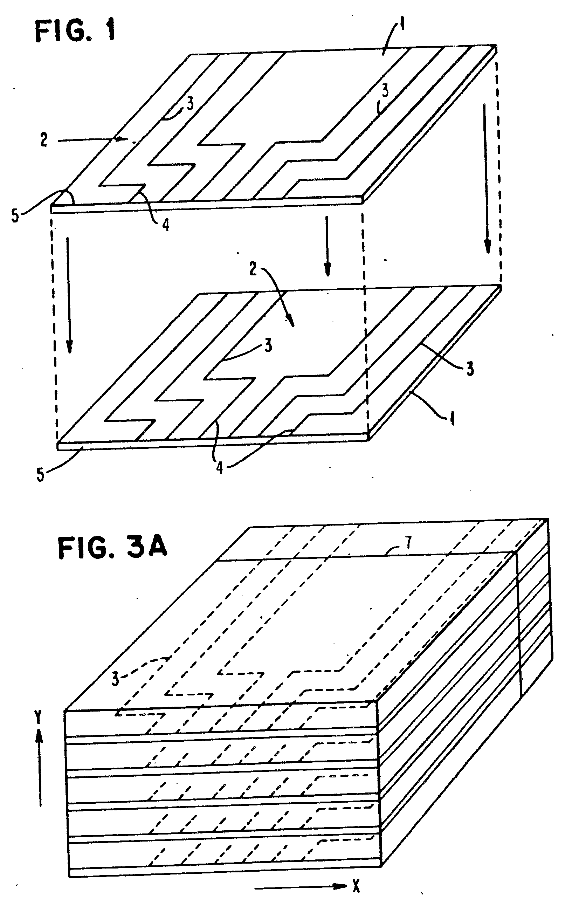

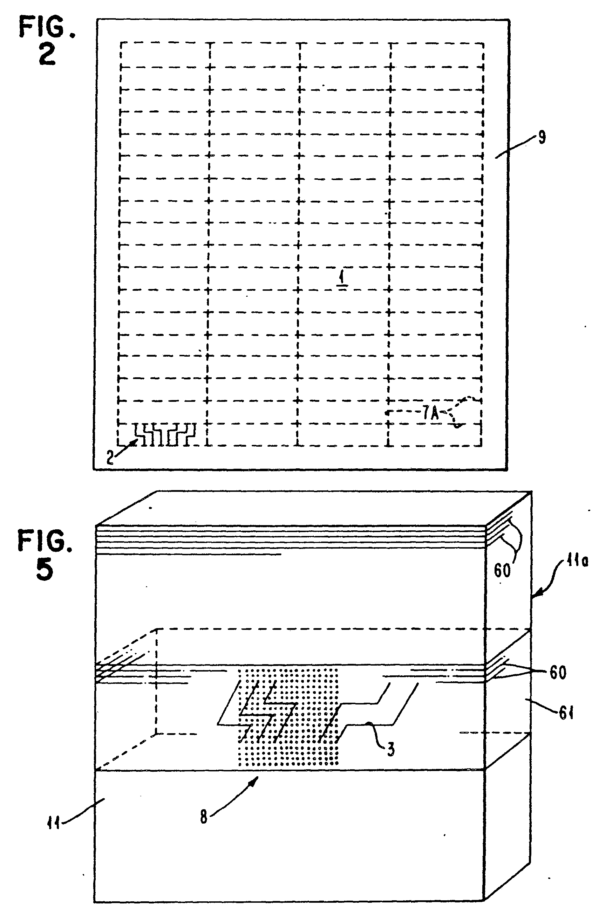

Die Herstellung eines Vielschichtsubstrates beginnt mit der Vorbereitung einer Vielzahl von dielektrischen, nicht fertig verarbeiteten, sog. Rohschichtblättern 1 in einer Form, die für das Aufbringen eines Metallbelages geeignet ist. Wie bekannt, umfasst das Vorbereiten der dielektrischen, rohen Schichtblätter 1 (Fig. 1) das Mischen von fein verteilten Partikeln aus Glas, Glaskeramik oder Keramik und anderen chemischen Zusätzen, wie organischen Lösungsmitteln und Bindemitteln, die in Streifen gegossen werden, die nach dem Verdampfen des Lösungsmittels schmiegsame Rohblätter bilden. Bis diese Blätter und die darin enthaltenen Partikel durch Brennen zusammengesintert sind, werden sie rohe Schichtblätter genannt.

Für die Herstellung von vielschichtigen, rohen Schichtblättersubstraten wird ein noch unentwikkeltes Leitermuster 2 auf den rohen Schichtblättern durch irgendein additives oder subtraktives bekanntes Verfahren aufgebracht. Beispielsweise kann das Muster gebildet werden durch Aufdampfen einer überdeckten Schicht eines leitenden Metalles auf das rohe Schichtblatt, gefolgt von der Zeichnung des gewünschten Musters durch photolithographische Verfahren. Alternativ kann das Muster auf bestimmten rohen Schichtblättern aufgebracht werden durch Siebdruck mittels einer Elektrodenpaste, die nach dem Brennen in ein Leitermuster umgewandelt wird (z.B. US-Patentschrift 3 456 158).

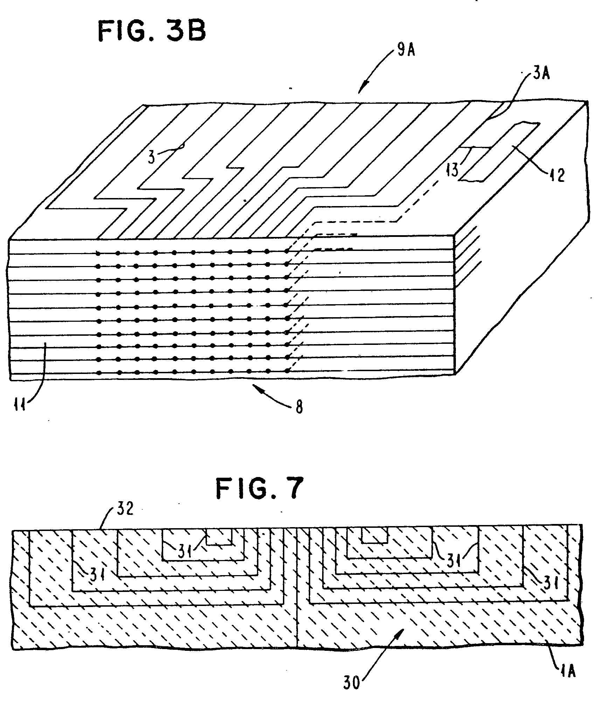

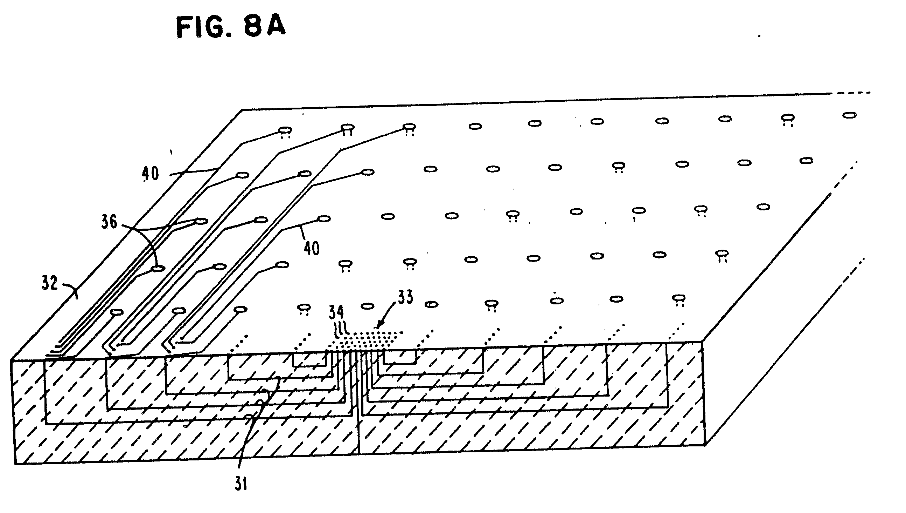

Das Leitermuster 2 besteht aus einer Mehrzahl von Leiterbahnen 3, die einander benachbarte Endteile 4 aufweisen, die an einer Kante 5 des rohen Schichtblattes enden, wo sie Kontaktpunkte eines Eingangsrasters 8 (Fig. 3B) bilden, das übereinstimmt mit entsprechenden Kontaktfeldern auf der Oberfläche eines integrierten Schaltungschips 6 (Fig. 6). Die Leiterbahnen 3 laufen auseinander, um benachbarte, gegenüberliegende Enden an einem vergrösserten Ausgangsraster 9A (Fig. 3B) zu bilden, die entlang der Schnittlinie 7 (Fig. 3A) angeordnet sind, welche die gegenüberliegende Kantenfläche 61 (Fig. 5) des rohen Schichtblattes definiert.

Wie in Fig. 2 gezeigt ist, können die rohen Schichtblätter von einem Mutterblatt 9 gebildet werden, indem eine Mehrzahl von Leitermustern 2 gleichzeitig für Durchgangszwecke verwendet werden kann. Die einzelnen rohen Schichtblätter 1 sind erhaltbar durch Trennen entlang der Schnittlinien 7A, vorzugsweise nach dem Laminieren.

Die Rasterteilung sowohl des Eingangs als auch Ausgangsrasters erstrecken sich in x–y-Richtungen. Die Rasterteilung in der x-Richtung ist definierbar durch geeignetes Gestalten der Leiterbahnen 3 auf der Oberfläche der rohen Schichtblätter 1. Die Rasterteilung in der y-Richtung ist auf verschiedene Weise erhaltbar. Beispielsweise können die rohen Schichtblätter gebildet werden aus verschiedener Dicke entsprechend der gewünschten y-Rasterteilung. Alternativ ist die Vielschichtstruktur erhaltbar aus rohen Schichtblättern von gleicher Dicke, die leere Blätter enthalten, die als Zwischenblätter zwischen mit Leiterbahnen versehenen Blättern dienen. Beispielsweise ist das Eingangsraster 8 bildbar mit einer Kontaktpunktteilung von 0,15 mm, die zum Ausgangsraster 9A zu grösser wird und dort eine Teilung von 0,25 bis 3,2 mm ergibt.

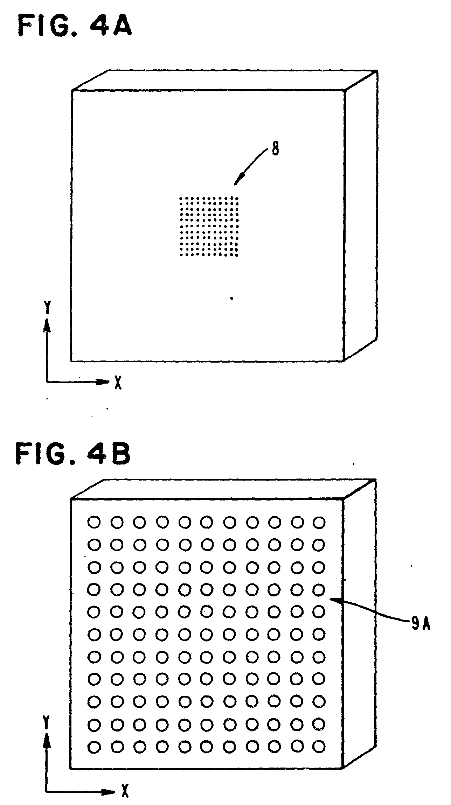

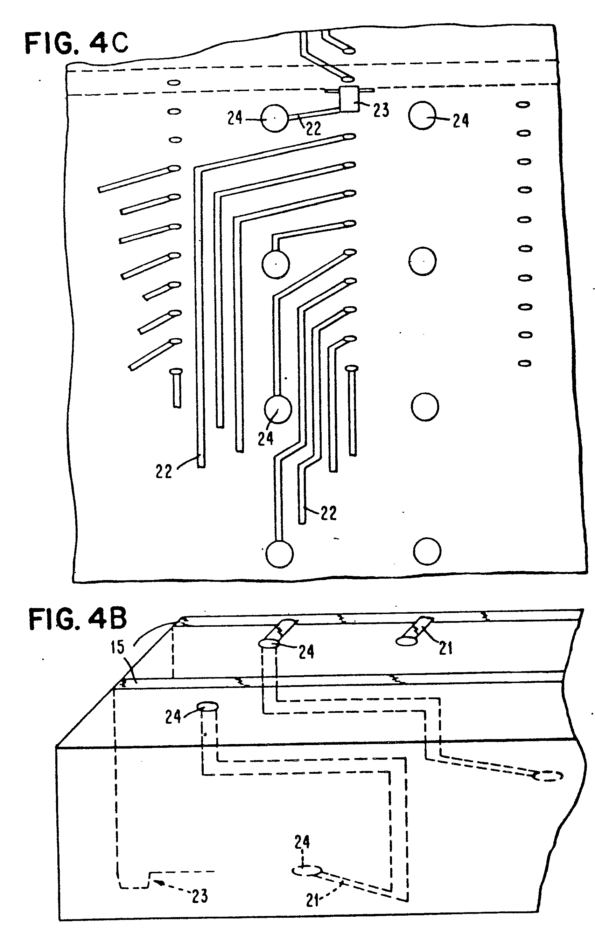

Durch geeignete Gestaltung der Leiterbahnen und dem Gebrauch von leeren, rohen Schichtblättern 60 kann die Eingangskantenfläche 11 oder die Ausgangskantenfläche 11a eines Vielschichtsubstrates (Fig. 5) mit genügend leeren Schichtblättern versehen werden, um die Verbindung mit anderen elektrischen Elementen, wie Widerständen, Kondensatoren und ähnlichem zu ermöglichen. Die Metallurgie kann auch Grundebenen, Spannungs-Verteilungsebenen und Leistungsebenen 15 (Fig. 4B) zwischen leeren Teilen von aneinanderliegenden, rohen Schichtblättern enthalten. In ähnlicher Weise können, wie in Fig. 3B gezeigt ist, die Leitermuster eines oder mehrerer roher Schichtblätter Querbahnen 13 enthalten, um die Metallurgie an eine Energiesammelleitung 12 anzupassen. Es ist klar, dass solche rohen Schichtblätter aus verschiedenen dielektrischen Materialien, wenn gewünscht, bestehen können, um die elektrischen Charakteristika der Struktur zu verbessern.

Wenn die Schichten aus vollständig metallüberzogenen, rohen Schichtblättern 15 (Fig. 4B) zwischen aufeinanderfolgende Lagen von Leitermusterblätter geschichtet sind, kann eine Serie von Doppelplatten gebildet werden. Die Platten können an jeder Seite der Leiterplatten angeordnet werden und rufen eine elektrische Streifenleiterausführung hervor, die bei elektrischer Vorspannung äquivalente Kondensatorplatten werden. Diese Doppelplatten 15 führen verschiedene Funktionen aus:

a) Sie erzeugen eine Verminderung des Kopplungsrauschens (Kreuzkopplung), das durch aktive Signalleiter erzeugt wird;

b) sie halten die Impedanz von Signalleitern fest; und

c) sie liefern Stellen für das physikalische und elektrische Verbinden von Leitungsein- und -ausgängen in paralleler Form in der Nähe des Chips, um die mit der Energieverteilung verbundene Induktanz zu mindern und das «Δi»-Rauschen zu vermindern, das bei Aktivierung der Schaltung eintritt. Die Spannung zu diesen Doppelplatten kann so festgelegt werden, um die elektrische Funktion und die physikalische Anordung von Chip und Träger zu optimieren.

Solche Leiterdoppelplatten 15 können in geeigneter Weise verbunden werden, so dass ihre Kapazität eine Entkopplung oder Filterfunktion ergeben kann. Die Doppelplatten können auch entfernt von den Signalleitern in Ebenen abgeordnet werden, die normalerweise für elektrische Funktionen nicht verwendet werden (Fig. 4B).

Andere geeignete Materialien (z.B. Widerstandspaste) können bei den rohen Schichtblättern (oder nach dem Brennen) angewandt werden, die innerhalb des Trägers einen Widerstand erzeugen können für derartige Funktionen wie Endwiderstände. Drosseln können in ähnlicher Weise gebildet werden.

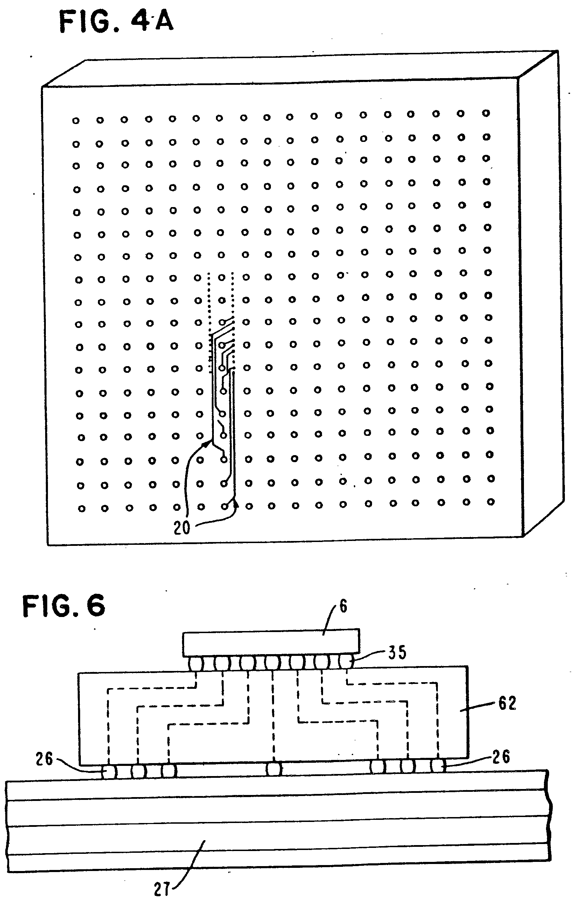

Die Flächen des Trägers können nach dem Lostrennen entlang der Schnittlinien 7 verwendet werden für das Vorsehen einer Oberfläche, über die eine zwischenverbindende Metallurgie 20, 21 und 22 (Fign. 4A, 4B und 4C) anwendbar ist. Diese Flächen können durch Polieren verbessert werden oder durch geeignete Überzüge, die eine Oberfläche erzeugen, die glatt genug ist für lithographische Verfahren. Leiternasen 23 (Fig. 4B) können vorgesehen werden, um für Trägerdickenveränderungen Kontaktpunkte und Verbindungen herzustellen.

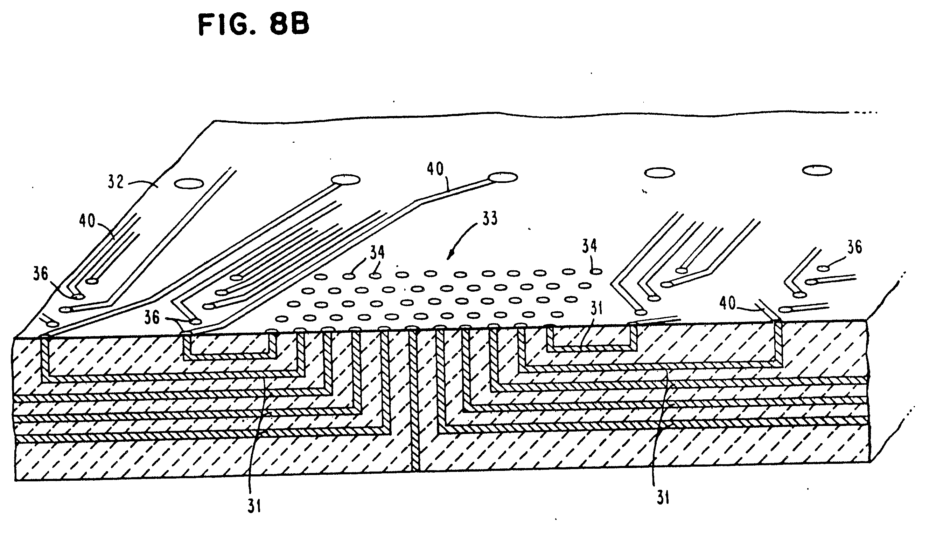

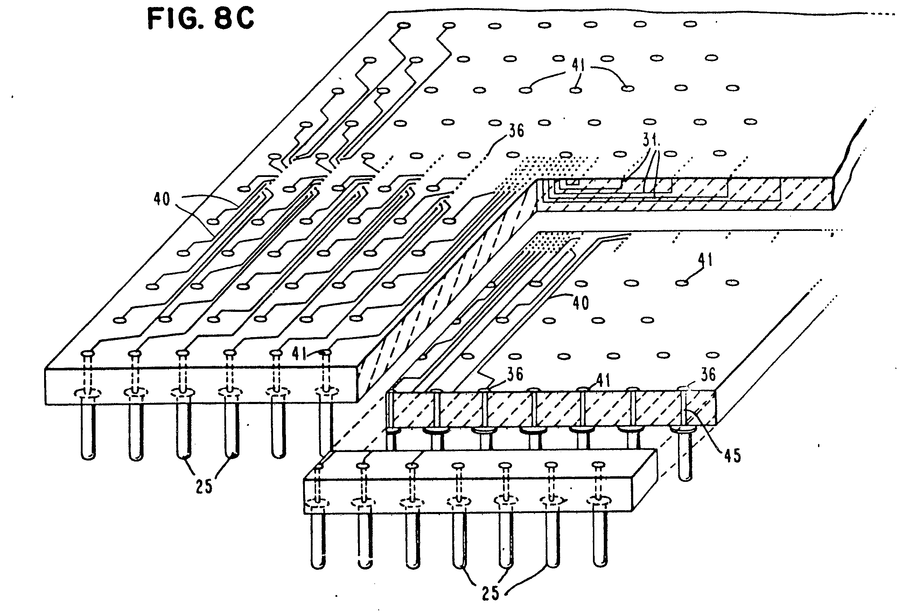

Eingangs-Ausgangspuffermetallbeläge 24 können an den Flächen des Trägers vorgesehen werden, um elektrische Verbindungen zu anderen Packungskomponenten zu bilden. Diese Eingangs-Ausgangsstrukturen können Kontaktstifte 25 (Fig. 8C), Lötmittelpuffer 26 (zur Chipverbindung, Fig. 6) oder andere Leitermaterialien umfassen. Die Anordnung des Chipträgers in nächster Nähe zur nächsten Schicht 27 (Fig. 6) der Packung zum Zwecke der Minderung der Induktanz ist ein Weg, um in den Genuss der Vorteile der genannten Chipverbindung zu gelangen. Eine angepasste Karte von geringer Ausdehnung, z.B. 27 (z.B. KEVLAR-basierend, Keramik niedriger Ausdehnung) ist verwendbar, um viele der vielschichtigen Träger der Erfindung aufzunehmen.

Eine Mehrzahl der vorbereiteten, rohen Schichtblätter werden übereinander gelagert (z.B. Fign. 3A und 5). Die Einheit wird dann in eine Presse eingegeben, die mit ausreichendem Druck eine Verbindung zwischen benachbarten Schichtblättern hervorruft. Die thermoplastische Natur des Binders in den rohen Schichtblättern verursacht, dass die verschiedenen Schichten aneinander festhaften, um einen einheitlichen Körper zu erzeugen. Wenn gewünscht, können einzelne Träger von Chips aus dem Mutterblock geschnitten werden, wenn Mutterschichtblätter 9 verwendet wurden. Der laminierte Stoss kann auch mit vollen oder teilweisen Durchgangslöchern oder Öffnungen versehen werden für Verstiftungsvorgänge als auch mit einer zusätzlichen Metallbeschichtung, wie Wiederverteilungsmustern 20, 21 und 22.

Auf jeden Fall sind die laminierten, rohen Schichtblätter in einen Sinterofen eingelegt zum Brennen, wobei der Binder ausgetrieben wird, normalerweise durch Auflösung, gefolgt von Sintern oder Vereinheitlichung der dielektrischen Partikel in Übereinstimmung mit bestehenden Techniken in eine vereinheitlichte Struktur 62.

Bei dem Ausführungsbeispiel nach Fig. 7 ist das Leitermuster 30 auf dem rohen Schichtblatt 1A U-förmig, so dass die Enden der einzelnen Leiterbahnen 31 an der gleichen Kante der Chipseite 32 des rohen Schichtblattes enden. Die Eingänge 34 sind in einem Raster angeordnet, um ein dichtes Kontaktfeld 33 zu bilden, d.h. Lötmittelhügel 35 sind in Übereinstimmung mit Kontaktfeldern auf der Oberfläche eines integrierten Schaltungschips 6 angeordnet. In beiden Ausführungsformen ist das integrierte Schaltungschip 6 mit den Eingängen 34 verbunden durch bekannte Verfahren, wie Lötmittel-Rückfluss oder anderes eutektisches Metallbefestigen.

Die Leiterbahnen 31 laufen von jedem Eingang 34 aus U-förmig zur Chipseitenkante 32, um Ausgangsanschlüsse 36 mit einer im wesentlichen vergrösserten seitlichen Teilung zu bilden. Auch die erforderliche orthogonale Teilung zwischen den Anschlussstellen ist durch Zwischenlegen von leeren, rohen Schichtblättern erzielbar.

Die vorbereiteten, rohen Schichtblätter werden dann aufeinander gestapelt und unter Druck zu einem Laminat verbunden. An diesem Punkt kann die Wiederverteilungsverdrahtung auf den Chipseitenflächen des Laminats zwischen den Ausgangsanschlüssen 36 und den Ausgangspunkten 41 mit einer vergrösserten Rasterteilung metallisiert werden. Es ist klar, dass die Wiederverteilungsverdrahtung 40 vor oder nach dem Trennen des Laminats aufgebracht werden kann.

Für das Einsetzen von Kontaktstiften 25 nach dem Brennen können Durchgangslöcher (von der Chipseite zur Rückseite des Trägers) durch das Laminat gelocht werden.

Auf jeden Fall wird dann das Laminat aus rohen Schichtblättern bei Temperaturen gebrannt, die ausreichen, um das Bindemittel auszubrennen und zu sintern oder die dielektrischen Partikel zu vereinheitlichen. Zu diesem Zeitpunkt können, wenn die Wiederverteilungsverdrahtung 40 nicht verwendet wurde, die Vorder- und Rückseiten poliert werden, zum photolithographischen oder auf andere Weise vorzunehmenden Aufbringen der Wiederverteilungsverdrahtung auf der gebrannten Struktur. Die Struktur kann vervollständigt werden durch das Einsetzen von Kontaktstiften 25 in Durchgangslöcher an den Ausgangspunkten 41.

**Patentansprüche**

1. Aus einer Mehrzahl von dielektrischen Schichten (1) zusammengesetztes und zu einer Einheit verbundenes dielektrisches Substrat mit einer Mehrzahl von sich zwischen benachbarten Schichten (1) erstreckenden Leiterbahnen (3), dadurch gekennzeichnet, dass die beiden Enden einer jeden Leiterbahn (3) an mindestens einer Kante der zugeordneten Schicht (1) enden und so Anschlussstellen bilden, wobei die einen Enden (34) für die Verbindung mit Halbleitervorrichtungen ein feines Raster (33 bzw. 8) darstellen und die anderen Enden (36) ein grobes Raster (9A) verkörpern, von dem aus Verteilungsleitungen (40) zu einem noch gröberen Raster von Anschlussstellen (41) verlaufen.

2. Dielektrisches Substrat nach Anspruch 1, dadurch gekennzeichnet, dass die Leiterbahn (3) sich zwischen gegenüberliegenden Enden der Schicht (1) erstrecken, wobei die Anschlussstellen an einer Seite der Oberfläche das feine Raster (8) bilden, von dem aus die Leiterbahnen (3) auseinanderlaufen und an der gegenüberliegenden Seite das grobe Raster (9A) bilden.

3. Dielektrisches Substrat nach Anspruch 2, dadurch gekennzeichnet, dass mit den Anschlussstellen (41) des gröbsten Rasters Kontaktstifte (25) verbunden sind.

4. Dielektrisches Substrat nach Anspruch 1, dadurch gekennzeichnet, dass die Leiterbahnen (3) U-förmig ausgebildet sind und so auf einer Fläche des dielektrischen Substrates sowohl das Fein- (33) als auch Grobraster von Anschlussstellen (34 bzw. 36) sich befinden.

**Claims**

1. Multi-layer dielectric substrate formed of a plurality of dielectric layers (1) and comprising a plurality of conductor runs (3) extending between adjacent layers (1), characterized in that the two ends of each conductor run (3) terminate at least at one edge of the associated layer (1), thus forming terminals, whereby the ends (34) for connection to semiconductor devices constitute a fine grid pattern (33 and 8, respectively) and the other ends (36) constitute a coarse grid pattern (9A) from which distribution lines (40) extend to an even coarser grid pattern (41).

2. Dielectric substrate according to claim 1, characterized in that the conductor runs (3) extend between opposite ends of the layer (1), whereby the terminals on one side of the surface form the fine grid pattern (8) from which the conductor runs (3) diverge, forming the coarse grid pattern (9A) on the opposite side.

3. Dielectric substrate according to claim 2, characterized in that contact pins (25) are connected to the terminals (41) of the coarsest grid pattern.

4. Dielectric substrate according to claim 1, characterized in that the conductor runs (3) are U-shaped, so that the fine (33) and coarse grid patterns of terminals (34 and 36, respectively) are on one surface of the dielectric substrate.

**Revendications**

1. Substrat diélectrique composé de plusieurs couches diélectriques (1) formant une unité et comportant plusieurs conducteurs (3) s'étendant entre les couches adjacentes (1), ledit substrat étant caractérisé en ce que les deux extrémités de chaque conducteur (3) aboutissent à au moins un des bords de la couche associée (1) formant ainsi des bornes, les extrémités (34) formant une configuration de grille fine (33 et 8 respectivement) pour la connexion à des dispositifs semiconducteurs, et les autres extrémités (36) formant une configuration de grille grossière (9A) de laquelle partent des lignes de distribution (40) vers une configuration de grille de bornes encore plus grossière (41).

2. Substrat diélectrique selon la revendication 1, caractérisé en ce que les conducteurs (3) s'étendent entre les extrémités opposées de la couche (1), les bornes formant, d'un côté de la surface, la configuration de grille fine (8) de laquelle partent en éventail les conducteurs (3) et du côté opposé la configuration de grille grossière (9A).

3. Substrat diélectrique selon la revendication 2, caractérisé en ce que des broches de contact (25) sont connectées aux bornes de connexion (41) de la configuration de grille la plus grossière.

4. Substrat diélectrique selon la revendication 1, caractérisé en ce que les conducteurs (3) ont une forme en U, de telle sorte que la configuration de grille fine et la configuration de grille de bornes grossière (34 et 36, respectivement) se trouvent sur une seule surface du substrat diélectrique.

FIG. 1
1
3
3
2
5
4
2
3
3
1
5
4

FIG. 3A
7
3
Y
X

FIG. 2
9
1
7A
2
FIG. 5
60
11a
60
61
3
11
8

FIG. 3B

9A
3A
3
13
12
11
8

FIG. 7

32
31
31
31
31
30
1A

FIG. 4A

8
Y
X

FIG. 4B

9A
Y
X

FIG. 4A
20

FIG. 6
6
35
62
26
26
27

FIG. 4C

24
23
24
22
24
22
22

FIG. 4B

15
24
21
24
24
23
21

33
34
40
31
40
36
32

FIG. 8A

36
40
31
34
31
33
40
34
31
36
32
40
36

FIG. 8B

45
36
41
31
41
40
36
36
41
25
41
25
40

FIG. 8C